# EUROPÄISCHE PATENTSCHRIFT

(11) **EP 1 640 648 B1**
(45) Veröffentlichungstag und Bekanntmachung des Hinweises auf die Patenterteilung: **02.04.2008**
(21) Anmeldenummer: 05019823.3
(22) Anmeldetag: 13.09.2005
(51) Int. Cl.: F16K 31/00, H01L 41/09

(54) **Aktoreinrichtung**
Actuator device
Dispositif actionneur

(30) Priorität: 28.09.2004 DE 102004046977
(43) Veröffentlichungstag der Anmeldung: 29.03.2006
(73) Patentinhaber: Festo AG & Co., 73734 Esslingen (DE)
(72) Erfinder: Dickhoff, Andreas, 73230 Kirchheim (DE)
(74) Vertreter: Abel, Martin

(56) Entgegenhaltungen:
- EP-A- 0 915 277
- DE-C1- 4 410 153
- DE-U1- 20 210 042
- US-A- 5 711 346

## Beschreibung

Die Erfindung betrifft eine Aktoreinrichtung, mit einem bezüglich einer Halterung fixierten Piezo-Biegewandler, der durch Anlegen einer Steuerspannung in einer Auslenkebene auslenkbar ist und der über eine Abstützeinrichtung derart bezüglich der Halterung abgestützt ist, dass bei seiner Auslenkung lokal ein in der Auslenkebene wirksames Drehmoment in ihn eingeleitet wird.

Eine aus der DE 4410153 C1 bekannte Aktoreinrichtung ist als zur Steuerung von Fluidströmen dienendes Ventil ausgebildet und enthält einen einenends an einer vom Ventilgehäuse gebildeten Halterung fixierten Piezo-Biegewandler, der andernends als Ventilglied ausgebildet ist, welches einem Ventilsitz gegenüberliegt. Um das Ventil umzuschalten, wird eine Steuerspannung an den Piezo-Biegewandler angelegt, sodass der verschwenkbare Arbeitsabschnitt des Piezo-Biegewandlers ausgelenkt und das daran vorgesehene Ventilglied mit einer gewissen Stellkraft an den Ventilsitz angedrückt wird.

Bei dieser bekannten Aktoreinrichtung ist der Piezo-Biegewandler mit axialem Abstand zum eingespannten Endabschnitt zusätzlich an einem Widerlager abgestützt. Dadurch soll die Kennlinie zu höherer Klemmkraft verschoben werden. Dies hat allerdings eine Verringerung der maximalen Auslenkung und folglich eine relativ geringe Leistung des Biegewandlers zur Folge.

Bei einer aus der DE 20210042 U1 bekannten Aktoreinrichtung ist ein Biegewandler durch Anlegen einer Steuerspannung ebenfalls in einer Auslenkebene auslenkbar. Zusätzlich ist ein verschwenkbar am Ventilgehäuse gelagertes Steuerglied vorhanden, das an einer Koppelstelle mit dem Biegewandler in beiden Verstelleinrichtungen bewegungsgekoppelt ist. Beim Aktivieren des Biegewandlers wird die Koppelstelle ebenfalls ausgelenkt und das damit bewegungsgekoppelte Steuerglied verschwenkt.

Es ist die Aufgabe der vorliegenden Erfindung, eine Aktoreinrichtung zu schaffen, mit der ein wesentlich effizienterer Betrieb des Piezo-Biegewandlers möglich ist.

Diese Aufgabe wird mit den Merkmalen des Patentanspruches 1 gelöst.

Auf diese Weise kann der Piezo-Biegewandler über seine gesamte Länge optimal ausgenutzt und damit seine Leistung gesteigert werden. Er wird in jeder Betriebssituation mit einem Drehmoment belastet, sodass er über seine gesamte wirksame Länge hinweg mit einem konstanten Krümmungsradius durchgebogen und somit auch durchgehend konstant beansprucht wird. Mithin wird der ausnutzbare Energieinhalt beträchtlich erhöht, und es kann beispielsweise eine höhere Stellkraft mit einem größeren Auslenkhub kombiniert werden. Bei einer Ausgestaltung als Ventil können somit im Vergleich zu einer konventionellen Bauweise bei vergleichbarer Baugröße wesentlich größere Strömungsquerschnitte gesteuert werden. Bei vergleichbaren Strömungsquerschnitten kann auf einen Biegewandler mit geringeren Abmessungen zurückgegriffen werden, was kompakte und kostengünstige Ventile ermöglicht. Die Aktoreinrichtung lässt sich allerdings auch auf anderen Gebieten als dem Ventilsektor vorteilhaft zur effizienten Erzeugung von Stellkräften einsetzen.

Von Vorteil ist, dass die Abstützeinrichtung mindestens einen in sich starren Abstützhebel aufweist, der zum einen drehmomentsteif an dem sich an den fixierten Endabschnitt anschließenden auslenkbaren Arbeitsabschnitt des Biegewandlers befestigt ist - der Befestigungsbereich sei als Drehmoment-Einleitungsstelle bezeichnet - und der zum anderen an einer bezüglich der den Piezo-Biegewandler tragenden Halterung ortsfesten Lagerstelle unter Gewährleistung eines Schwenkfreiheitsgrades abgestützt ist. Die sich hierbei ergebende Schwenkachse verläuft rechtwinkelig zur Auslenkebene des Biegewandlers. Die Abstützung erfolgt rechtwinkelig dazu, in der Auslenkebene. Wird der Biegewandler betätigt, arbeitet er dabei gegen eine Widerstandskraft, wobei an der Lagerstelle eine gleichgroße Abstützkraft als Reaktionskraft in den Abstützhebel eingeleitet wird. Durch dieses Kräftepaar wird ein Drehmoment erzeugt, welches an der Stelle, an der der Abstützhebel am Biegewandler steif befestigt ist, in den Biegewandler eingeleitet wird. Dieses Drehmoment wird vom Biegewandler über seinen fixierten Endabschnitt in die Halterung eingeleitet, sodass sich insgesamt, über die Länge des Biegewandlers hinweg, eine gleichmäßige Belastung des Biegewandlers einstellt.

Vorteilhafte Weiterbildungen der Erfindung gehen aus den Unteransprüchen hervor.

Es kann vorgesehen sein, dass der Piezo-Biegewandler lediglich einenends bezüglich der Halterung fixiert ist, beispielsweise durch eine am einen Endabschnitt erfolgte feste Einspannung in einer Halterung. Möglich ist allerdings beispielsweise auch eine mehrfache Fixierung, insbesondere an entlang des Umfanges des Piezo-Biegewandlers verteilten, zueinander beabstandeten Stellen. Beispielsweise kann der Piezo-Biegewandler über eine Membrananordnung entsprechend mehrfach aufgehängt sein.

Es ist möglich, den Piezo-Biegewandler auf einer Membran anzuordnen, die umfangsseitig entweder ringsum durchgehend oder an mehreren Stellen mit elastischen Aufhängungsabschnitten über den Rand des Piezo-Biegewandlers hinausragt, wobei sie über den/die hinausragenden Abschnitt(e) an einer beispielsweise von einem Gehäuse gebildeten Halterung fixiert ist.

Die Einleitung des Drehmoments in den Piezo-Biegewandler kann in demjenigen Bereich des Biegewandlers stattfinden, an dem dieser seine Stellkraft abgibt, beispielsweise um eine Ventilöffnung zu verschließen oder um gegen die Kraft einer Rückstellfeder eine Auslenkung hervorzurufen. Der Biegewandler arbeitet hier gegen einen Widerstand, wobei er stets so durchgebogen ist, dass seine Biegelinie einen Kreisbogen beschreibt.

Andererseits ist es auch möglich, die Anordnung so zu treffen, dass die Drehmoment-Einleitungsstelle und die Stellkraft-Abgabestelle mit Abstand zueinander angeordnet sind, relativ zueinander also unterschiedliche Positionen einnehmen und nicht zusammenfallen. Die Stellkraft-Abgabestelle kann an der Abstützeinrichtung vorgesehen sein.

Eine sehr gute Ausnutzung der Biegewandlerlänge ist möglich, wenn die Drehmoment-Einleitungsstelle im Bereich des dem fixierten Endbereich entgegengesetzten Endbereiches des Biegewandlers vorgesehen ist. Dort befindet sich zweckmäßigerweise auch die Stellkraft-Abgabestelle.

Die Lagerstelle kann unmittelbar an der entsprechend ausgebildeten Halterung vorgesehen sein. In der Regel besitzt man jedoch eine verbesserte Gestaltungsfreiheit, wenn die Lagerstelle an einem gesonderten Lagerstellenträger vorgesehen ist, der seinerseits an der Halterung befestigt ist und der sich ausgehend von dort ein Stück weit längs des Biegewandlers erstreckt. Der Lagerstellenträger fungiert in diesem Fall quasi als Hilfshebel, der über die Lagerstelle mit dem Abstützhebel zusammenwirkt, um für diesen die gewünschte Abstützung zu bewirken.

Der Biegewandler und der Lagerstellenträger können unabhängig voneinander an der Halterung befestigt werden. Vorteilhaft ist eine Bauform, bei der der Biegewandler unter Zwischenschaltung des Lagerstellenträgers an der Halterung fixiert ist.

Die Lagerstelle für den Abstützhebel ist zweckmäßigerweise weniger weit vom fixierten Endabschnitt des Biegewandlers entfernt als die Drehmoment-Einleitungsstelle. Somit erstreckt sich der Abstützhebel ausgehend von der Drehmoment-Einleitungsstelle ein Stück weit zurück in Richtung des fixierten Endabschnittes des Biegewandlers, wobei er längsseits neben dem Arbeitsabschnitt des Biegewandlers angeordnet ist. Handelt es sich bei dem Abstützhebel um ein lineares Gebilde, kann dessen Längsachse im unausgelenkten Ausgangszustand des Biegewandlers parallel zu dessen Längsachse verlaufen.

Der Abstützhebel wird aufgrund der Tatsache, dass sich der Biegewandler bei der Aktivierung durchbiegt, während er selbst in sich starr ist und bei den anfallenden Beanspruchungen keine relevante Durchbiegung erfährt, auch mit einer in seiner Längsrichtung wirkenden Zugkraft beaufschlagt. Damit diese die Verformung des Biegewandlers nicht behindert, ist die Lagerstelle zweckmäßigerweise mit den Eigenschaften eines Loslagers ausgeführt, an dem der Abstützhebel unter Gewährleistung eines zusätzlichen translatorischen Freiheitsgrades entgegen der momentanen Auslenkrichtung des Arbeitsabschnittes des Biegewandlers abgestützt ist.

Bevorzugt ist die Lagerstelle etwa mittig zwischen der Drehmoment-Einleitungsstelle und dem an der Halterung fixierten Endabschnitt des Biegewandlers angeordnet. Als besonders vorteilhaft erweist sich eine dahingehende Platzierung, dass sie sich auf gleicher Höhe mit der neutralen Faser des Biegewandlers befindet.

Es ist möglich, einen Abstützhebel oberhalb und/oder unterhalb und/oder seitlich des Arbeitsabschnittes des Biegewandlers vorzusehen. Insbesondere in Verbindung mit einer Zweifachanordnung kann relativ einfach die gewünschte Abstützwirkung bei beiden Auslenkrichtungen des Biegewandlers hervorgerufen werden. Mit den Begriffen "oberhalb" und "unterhalb" sind diejenigen Seiten des Biegewandlers zu verstehen, die dessen beiden größeren Flächen zugeordnet sind, unabhängig von der momentanen Ausrichtung des Biegewandlers im Raum.

Der Abstützhebel kann bevorzugt auch als Hohlkörper ausgeführt sein, der den Arbeitsabschnitt entlang eines Teils seiner Länge umschließt, wobei die Querschnittsabmessungen des Hohlraumes so groß sind, dass zwischen dem Arbeitsabschnitt und dem Hohlkörper die für die Einleitung des Drehmoments erforderliche relative Schwenkbewegung kollisionsfrei möglich ist.

Nachfolgend wird die Erfindung anhand der beiliegenden Zeichnung näher erläutert. In dieser zeigen:
- Figur 1: in einer stark vergrößerten schematischen Längsschnittdarstellung eine mögliche erste Bauform der erfindungsgemäßen Aktoreinrichtung im deaktivierten Ausgangszustand des Piezo-Biegewandlers,
- Figur 2: die Anordnung aus Figur 1 bei aktiviertem, ausgelenktem Biegewandler, wobei ergänzend ein die Beanspruchung des Biegewandlers wiedergebendes Belastungsdiagramm eingezeichnet ist,
- Figur 3: eine weitere, alternative Bauform der Aktoreinrichtung in stark schematisierter Darstellung, wobei der deaktivierte Ausgangszustand des Biegewandlers gezeigt ist,
- Figur 4: die Anordnung aus Figur 3 im Längsschnitt gemäß Schnittlinie IV-IV,
- Figur 5: die Anordnung aus Figur 3 bei in die eine Richtung ausgelenktem Biegewandler,
- Figur 6: die Anordnung aus Figur 5 im Längsschnitt gemäß Schnittlinie VI-VI,
- Figur 7: eine mit der Darstellung der Figur 6 vergleichbare Schnittdarstellung bei in die entgegengesetzte Richtung ausgelenktem Biegewandler, und
- Figur 8: eine modifizierte Ausführungsform in schematischer Darstellung.

Die in den Ausführungsbeispielen abgebildeten und insgesamt mit Bezugsziffer 1 bezeichneten Aktoreinrichtungen sind als Ventile konzipiert, die eine Steuerung von Fluidströmen sowohl gasförmiger als auch flüssiger Art ermöglichen. Das erfindungsgemäße Konzept lässt sich allerdings bei sämtlichen Anwendungen einsetzen, bei denen mittels eines Biegewandlers Stellkräfte ausgeübt werden sollen.

Die Aktoreinrichtung 1 verfügt über ein beim Ausführungsbeispiel als Ventilgehäuse fungierendes Gehäuse 2, das eine Arbeitskammer 3 definiert, in die ein Piezo-Biegewandler 4 hineinragt.

Der im Folgenden zur Vereinfachung lediglich als Biegewandler angesprochene Piezo-Biegewandler 4 ist ein längliches, balken- oder leistenförmiges Bauteil und ist mit seinem einen stirnseitigen Endbereich 6 - im Folgenden als "fixierter Endbereich" bezeichnet - an dem Gehäuse 2 bezüglich diesem unbeweglich fixiert. Das Gehäuse 2 fungiert insoweit als Halterung 7 für den Biegewandler 4, die allerdings bei anderer Konzeption der Aktoreinrichtung 1 nicht zwingend eine Gehäusefunktion übernehmen muss.

Der fixierte Endbereich 6 ist beim Ausführungsbeispiel in die Halterung 7 eingespannt. Elektrische Leiter 8, die das Anlegen einer Steuerspannung an den Biegewandler 4 ermöglichen, sind aus der Halterung 7 herausgeführt.

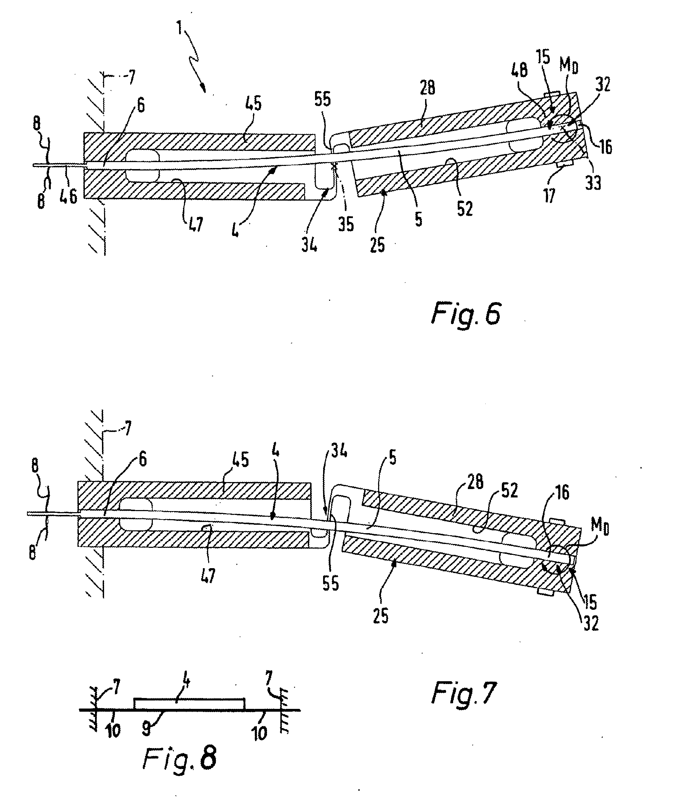

Abweichend von dieser Anordnung ist allerdings auch beispielsweise eine mehrfache Fixierung des Biegewandlers 4 möglich, insbesondere an entlang des Umfanges des Piezo-Biegewandlers verteilten, zueinander beabstandeten Stellen. Hierzu kann der Piezo-Biegewandler 4 über eine Membrananordnung entsprechend mehrfach aufgehängt sein. Zum Beispiel ist es möglich, den Piezo-Biegewandler auf einer Membran 9 anzuordnen, die umfangsseitig an mehreren Stellen mit elastischen Aufhängungsabschnitten 10 über den Rand des Piezo-Biegewandlers 4 hinausragt, über die die Membran 9 an einer beispielsweise von einem Gehäuse gebildeten Halterung 7 fixiert ist. Alternativ kann die den Biegewandler 4 tragende Membran 9 auch ringsum mittels eines einzigen, durchgehenden Aufhängungsabschnittes 10 bezüglich einer Halterung 7 fixiert sein. Diese Bauformen sind in Figur 8 schematisch, ohne Darstellung der Abstützeinrichtung, illustriert.

Der Aufbau des Biegewandlers 4 als solches kann den aus dem Stand der Technik bekannten Bauformen entsprechen. In der Regel wird er ein Trägerelement aufweisen, das an einer oder beiden seiner zwei größerflächigen Seiten ein- oder mehrfach mit piezoelektrischem Material beschichtet ist. Ein Multilayer-Aufbau ist möglich.

Der Biegewandler 4 ragt vom fixierten Endbereich 6 mit einem frei endenden Arbeitsabschnitt 5 weg und dabei, bei den Ausführungsbeispielen, frei endend in die Arbeitskammer 3 hinein.

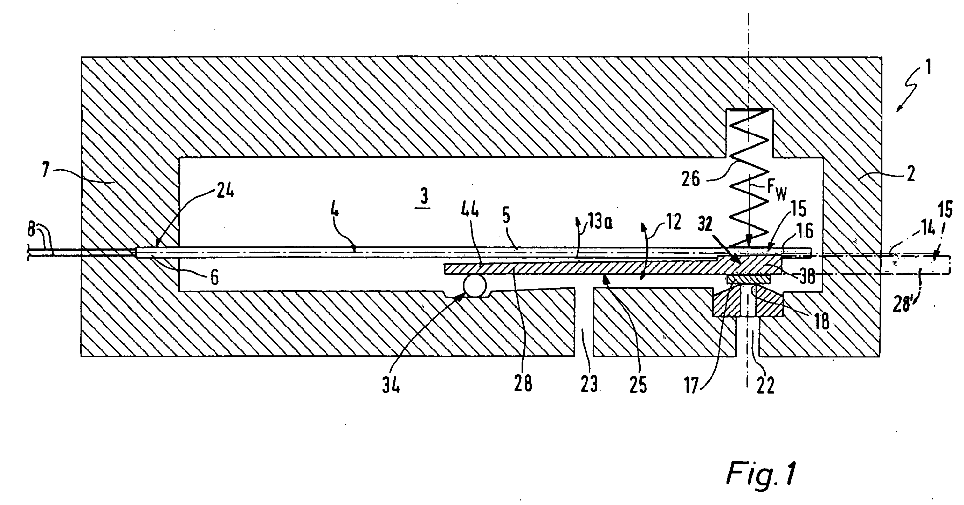

Im deaktivierten, also spannungslosen Ausgangszustand nimmt der Biegewandler 4 die aus Figuren 1, 3 und 4 ersichtliche lineare Gestalt ein. Durch Anlegen einer Steuerspannung wird er aktiviert und quer zu seiner Längsachse zu einer Auslenkung in einer Auslenkebene veranlasst, die in Figuren 1, 2, 4, 6 und 7 mit der Zeichenebene zusammenfällt. Die Auslenkbewegung 12, die bei den Ausführungsbeispielen eine Schwenkbewegung des Arbeitsabschnittes 5 ist, ist in der Zeichnung mit einem Doppelpfeil verdeutlicht.

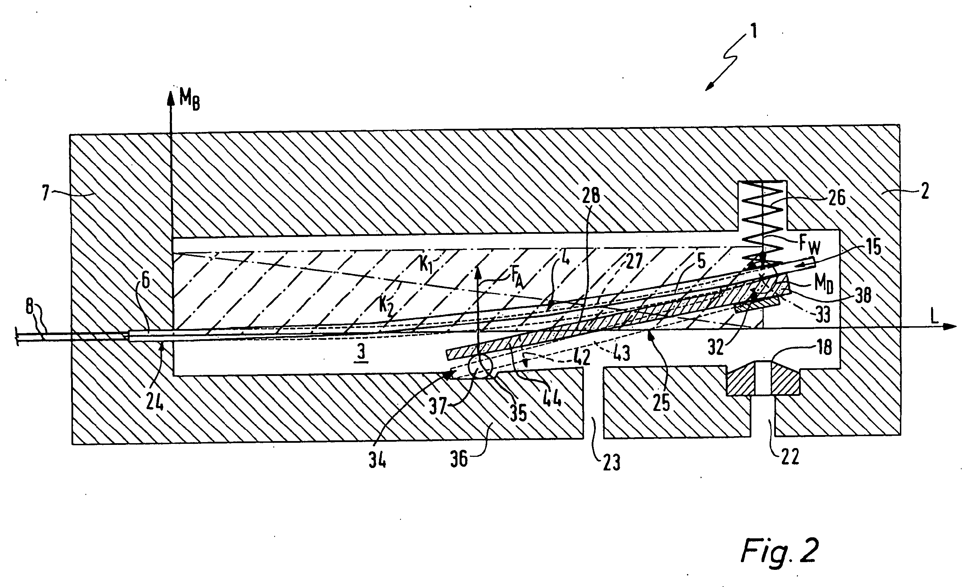

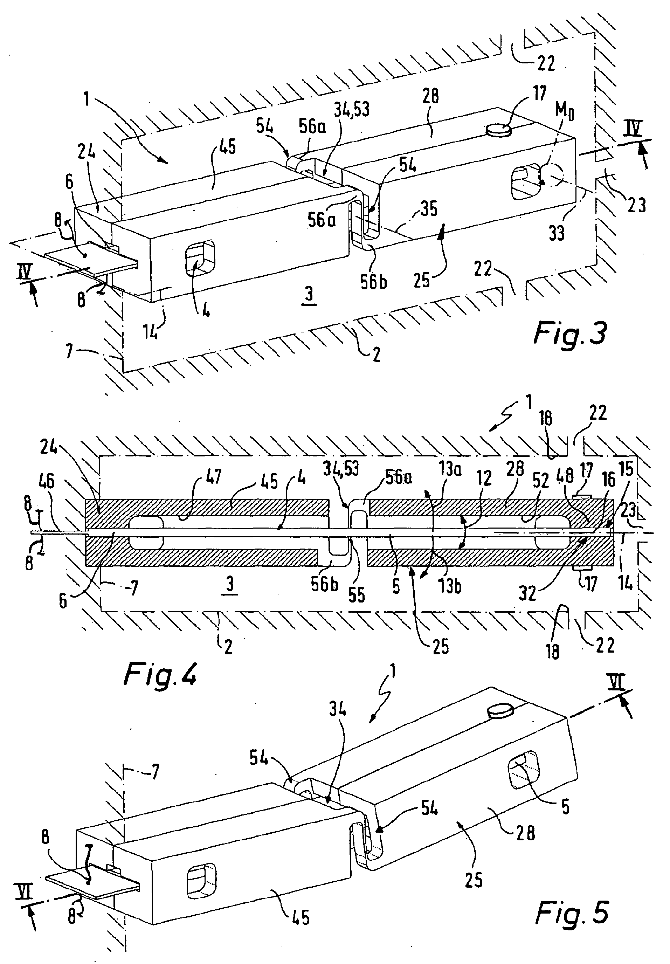

Der Biegewandler 4 des Ausführungsbeispiels gemäß Figuren 1 und 2 ist so konzipiert, dass er ausgehend von seinem Ausgangszustand in nur einer Auslenkrichtung 13a aktiv seitwärts auslenkbar ist. Demgegenüber ermöglicht der Biegewandler 4 des Ausführungsbeispiels der Figuren 3 bis 7 eine aktive Auslenkung in beide Richtungen, wobei die entsprechenden Auslenkrichtungen 13a, 13b auch hier durch Pfeile angedeutet sind.

Der Biegewandler 4 hat insgesamt eine flächige Gestalt, wobei die Auslenkebene rechtwinkelig zu der in Figuren 1 und 4 strichpunktiert angedeuteten, zur Zeichenebene rechtwinkeligen Hauptausdehnungsebene 14 des Biegewandlers 4 ausgerichtet ist. Soweit vorliegend von oberhalb oder unterhalb des Biegewandlers 4 gesprochen wird, sind die diesseits und jenseits der Hauptausdehnungsebene 14 liegenden Bereiche gemeint und sind die entsprechenden Begriffe nicht einschränkend auf eine bestimmte Orientierung der Aktoreinrichtung 1 im Raum zu verstehen.

Dem Biegewandler 4 ist eine Stellkraft-Abgabestelle 15 zugeordnet, mit der er bei seiner Aktivierung die durch das Anlegen der elektrischen Spannung hervorgerufene Stellkraft nach außen abgibt. Die Stellkraft-Abgabestelle 15 befindet sich am Arbeitsabschnitt 5 mit Abstand zum fixierten Endbereich 6 und ist insbesondere im Bereich des dem fixierten Endbereich axial entgegengesetzten freien Endbereiches 16 des Biegewandlers 4 vorgesehen.

Bei den Ausführungsbeispielen ist der Stellkraft-Abgabestelle 15 mindestens ein Ventilglied 17 zugeordnet. Es befindet sich im Bereich der Oberseite und/oder Unterseite des Biegewandlers 4 und liegt jeweils einem gehäusefesten Ventilsitz 18 gegenüber, der die Öffnung eines zu steuernden Ventilkanals 22 umgrenzt. Je nachdem, ob das Ventilglied 17 vom Ventilsitz 18 abgehoben ist oder an diesem anliegt, kann ein Druckmedium durch den zugeordneten Ventilkanal 22 hindurchströmen oder nicht.

Die Aktoreinrichtung 1 gemäß Figuren 1 und 2 bildet ein 2/2-Wegeventil. Zusätzlich zu dem einen, gesteuerten Ventilkanal 22 mündet noch ein weiterer, ungesteuerter Ventilkanal 23 in die Arbeitskammer 3 hinein. Ein über den gesteuerten Ventilkanal 22 zugeführtes Druckmedium kann bei abgehobenem Ventilglied 17 durch die Arbeitskammer 3 hindurch in den ungesteuerten Ventilkanal 23 überströmen.

Die Aktoreinrichtung 1 gemäß Figuren 3 bis 7 ist als 3/2-Wegeventil konzipiert. Der Biegewandler 4 trägt hier an entgegengesetzten Seiten zwei Ventilglieder 17, die jeweils einem von zwei gesteuerten Ventilkanälen 22 zugeordnet sind, wobei auch hier noch ein zusätzlicher ungesteuerter Ventilkanal 23 in die Arbeitskammer 3 einmündet. Durch entsprechende Aktivierung des Biegewandlers 4 kann wahlweise einer der beiden gesteuerten Ventilkanäle 22 geschlossen werden, um gleichzeitig die Verbindung zwischen dem dann offenen anderen gesteuerten Ventilkanal 22 und dem ungesteuerten Ventilkanal 23 herzustellen.

Diese Ventilfunktionalitäten sind zwar besonders vorteilhaft, gleichwohl als nicht abschließende exemplarische Anwendungsfälle zu verstehen.

Zusätzlich zu seiner drehmomentsteifen Einspannung im Bereich der dem fixierten Endbereich 6 zugeordneten Einspannstelle 24 ist der Biegewandler 4 in vorteilhafter Weise mittels einer von dieser Einspannung unabhängigen Abstützeinrichtung 25 bezüglich der Halterung 7, vorliegend dem Gehäuse 2, abgestützt. Durch diese Abstützeinrichtung 25 wird in den Biegewandler 4 bei Auslenkung seines Arbeitsabschnittes 5 lokal ein in der Auslenkebene wirksames Drehmoment M_{D} eingeleitet. Dieses Drehmoment M_{D} verursacht über die gesamte Länge des Arbeitsabschnittes 5 hinweg eine konstante, kreisbogenförmige Krümmung des Biegewandlers 4 unabhängig vom Belastungsfall. Die Biegelinie des Biegewandlers 4 folgt also einer Kreislinie, wie dies aus Figuren 2, 6 und 7 leicht nachvollziehbar ist.

Dieser bewusst hervorgerufene Belastungsfall hat zum Ergebnis eine konstante Biegebeanspruchung des Biegewandlers 4 über die gesamte Länge seines wirksamen Arbeitsabschnittes 5 hinweg. Dies ist in dem der Figur 2 überlagerten Belastungsdiagramm dargestellt, in dem das an der Biegewandler-Oberfläche herrschende Biegemoment M_{B} über die Länge L des Arbeitsabschnittes 5 des Biegewandlers 4 aufgetragen ist.

Das Belastungsdiagramm zeigt anhand einer strichpunktierten, waagrechten Linie K₁ die konstant hohe Biegebeanspruchung des Biegewandlers 4 mit dem strichpunktiert schraffiert darunter angedeuteten Energieinhalt. Zum Vergleich dazu ist durch eine doppelt strichpunktierte Linie K₂ die Belastungssituation eines konventionell betriebenen Biegewandlers 4 eingezeichnet, aus der ersichtlich ist, dass dort die Belastung ausgehend von einem an der Einspannstelle 24 vorliegenden Maximalwert bis auf ein Minimum an der Stellkraft-Abgabestelle 15 abnimmt. Dementsprechend ist dort die Beanspruchung des Biegewandlers 4 insgesamt erheblich geringer, wobei sie weit unterhalb der eigentlich möglichen Nutzbarkeitsschwelle des Biegewandlers 4 liegt.

Ersichtlich kann bei den erfindungsgemäßen Aktoreinrichtungen 1 die Effizienz und somit der Wirkungsgrad des Biegewandlers 4 gegenüber konventionellen Bauformen um ein Mehrfaches gesteigert werden. Erste Erfahrungen haben gezeigt, dass die Leistung des Biegewandlers 4 um wenigstens das Dreifache gegenüber einer herkömmlichen Ausführungsform gesteigert werden kann, ohne hierbei die mechanische Belastung des Biegewandlers 4 zu erhöhen.

Unter Zugrundelegung der Figuren 1 und 2 lassen sich weitere Vorteile der Abstützeinrichtung 25 besonders anschaulich erläutern. Dort ist vorgesehen, dass der Arbeitsabschnitt 5 an seiner Stellkraft-Abgabestelle 15 durch eine von einer Rückstellfeder 26 herrührende Widerstandskraft Fw beaufschlagt wird, um das mit dem Arbeitsabschnitt 5 bewegungsgekoppelte Ventilglied 17 in Richtung der Schließstellung, zur Anlage am Ventilsitz 18, zu beaufschlagen. Die Widerstandskraft F_{W} ist ausreichend groß zu bemessen, um das Ventilglied 17 gegen die entgegengesetzt wirksame Fluidkraft, welche aus dem im gesteuerten Ventilkanal 22 anstehenden Druck resultiert, in der Schließstellung zu halten. Weil durch die zusätzliche Abstützeinrichtung 25 bei vergleichbarer Größe des Biegewandlers 4 eine größere Stellkraft als bei konventionellem Aufbau realisierbar ist, kann folglich eine stärkere Rückstellfeder 26 verwendet werden, was die Realisierung größerer Ventilsitzdurchmesser und somit größerer Strömungsquerschnitte zulässt. Da wegen der höheren Leistung auch ein größerer Auslenkhub des Arbeitsabschnittes 5 möglich ist, lassen sich letztlich bei einem Ventil gleicher Größe wesentlich höhere Durchflusswerte realisieren.

Andererseits können zum Erhalt vergleichbarer Durchflusswerte die Abmessungen des Biegewandlers 4 verglichen mit einem konventionellen Ventil erheblich reduziert werden.

Die genannten Vorteile sind unabhängig davon, wodurch die Widerstandskraft Fw erzeugt wird. Beispielsweise kann die Widerstandskraft von einem Bauteil einer beliebigen Vorrichtung gebildet sein, das durch den Biegewandler verlagert werden soll.

In Figur 2 ist in gestrichelten Linien bei 27 die gekrümmte Gestalt eines Biegewandlers angedeutet, der konventionell, ohne zusätzliche Abstützeinrichtung 25, betrieben wird. Man erkennt hier den typischen Biegeverlauf mit ausgehend von der Einspannstelle 24 zunächst nur schwach gekrümmtem Arbeitsabschnitt, dessen Krümmung dann zur Stellkraft-Abgabestelle 15 hin zunimmt. Im Vergleich dazu ist in durchgezogenen Linien die durchgehend einen Kreisbogen beschreibende Gestalt des erfindungsgemäß zusammen mit einer Abstützeinrichtung 25 eingesetzten Biegewandlers 4 zu erkennen.

Bei beiden Ausführungsbeispielen beinhaltet die Abstützeinrichtung 25 einen in sich starren Abstützhebel 28, der einenends in demjenigen Bereich des Arbeitsabschnittes 5 am Biegewandler 4 befestigt ist, in dem das Drehmoment M_{D} eingeleitet werden soll, wobei der entsprechende Bereich als Drehmoment-Einleitungsstelle 32 bezeichnet sei.

Die Drehmoment-Einleitungsstelle 32 befindet sich insbesondere im Bereich des freien Endbereiches 16 des Biegewandlers 4, wie dies bei allen Ausführungsbeispielen der Fall ist.

Bei den Ausführungsbeispielen fallen die Drehmoment-Einleitungsstelle 32 und die Stellkraft-Abgabestelle 15 des Biegewandlers 4 zusammen. Sie können aber auch unterschiedliche relative Positionen zueinander einnehmen, um insbesondere Anpassungen von Kraft und Hub vorzunehmen.

So wäre es beispielsweise möglich, dass sich der Abstützhebel 28 - wie dies in Figur 1 strichpunktiert bei 28' angedeutet ist - auf der der Lagerstelle 34 entgegengesetzten Seite über die Drehmoment-Einleitungsstelle 32 hinaus erstreckt und zweckmäßigerweise sogar über den Biegewandler 4 hinausragt, wobei sich dann die Stellkraft-Abgabestelle 15 an dem über den Biegewandler 4 hinausragenden Endabschnitt des Abstützhebels 28 befindet. Dort kann dann beispielsweise die Rückstellfeder 26 angreifen und kann auch das Ventilglied 17 vorgesehen sein, sodass letzteres nicht am Biegewandler 4, sondern an der Abstützeinrichtung 25 angeordnet ist.

Der Abstützhebel 28 ist an der Drehmoment-Einleitungsstelle 32 drehmomentsteif am Arbeitsabschnitt 5 befestigt, wobei er in der Lage ist, bezüglich einer zur Auslenkebene rechtwinkeligen Achse - im Folgenden als Drehmomentachse 33 bezeichnet - ein Drehmoment auf den Arbeitsabschnitt 5 zu übertragen, wenn er bezüglich der Drehmomentachse 33 aufgrund externer Kräfte verschwenkt wird.

Bevorzugt liegt zwischen dem Abstützhebel 28 und dem Biegewandler 4 eine komplett starre Verbindung vor, beispielsweise indem der Abstützhebel 28 mit dem Biegewandler 4 verschweißt oder verklebt ist oder indem der Biegewandler 4 im entsprechend ausgebildeten Abstützhebel 28 fest eingespannt ist. Die erste Variante ist exemplarisch beim Ausführungsbeispiel der Figuren 1 und 2 verwirklicht, während die zweite Befestigungsvariante beim Ausführungsbeispiel der Figuren 3 bis 7 vorgesehen ist.

Ausgehend von der Drehmoment-Einleitungsstelle 32 erstreckt sich der Abstützhebel 28 zweckmäßigerweise längsseits neben dem Arbeitsabschnitt 5 in Richtung zu der Einspannstelle 24, wobei er mit Abstand zu dieser an einer bezüglich der Halterung 7 ortsfesten Lagerstelle 34 schwenkbeweglich abgestützt ist. Der dabei verliehene Schwenkfreiheitsgrad bezieht sich auf eine zur Auslenkebene rechtwinkelige Schwenkachse 35, wobei die Abstützung entgegen der momentanen Auslenkrichtung des Biegewandlers 4 verläuft und mithin eine mit der momentanen Auslenkrichtung zusammenfallende Reaktionskraft als Abstützkraft F_{A} an der Lagerstelle 34 in den Abstützhebel 28 eingeleitet wird.

Die Lagerstelle 34 liegt näher bei dem fixierten Endbereich 6 des Biegewandlers 4 als die Drehmoment-Einleitungsstelle 32. Als besonders zweckmäßig hat es sich erwiesen, die Lagerstelle 34 mittig zwischen der Drehmoment-Einleitungsstelle 32 und dem fixierten Endbereich 6 zu platzieren.

Beim Ausführungsbeispiel der Figuren 1 und 2 erstreckt sich der Abstützhebel 28 unterhalb des Arbeitsabschnittes 5 des Biegewandlers 4, also auf derjenigen Seite des Biegewandlers 4, die derjenigen Seite entgegengesetzt ist, zu der hin der Arbeitsabschnitt 5 beim Aktivieren des Biegewandlers 4 ausgelenkt wird.

Alternativ könnten Abstützhebel 28 und Lagerstelle 34 auch auf der entgegengesetzten Seite angeordnet sein, wenn bei entgegengesetzter Auslenkung des Arbeitsabschnittes 5 eine Drehmomenteinleitung gewünscht ist. Handelt es sich um einen aktiv nach beiden Seiten auslenkbaren Biegewandler 4, kann sowohl oberhalb als auch unterhalb des Arbeitsabschnittes 5 ein Abstützhebel 28 mit zugeordneter Lagerstelle 34 vorgesehen sein.

Beim Ausführungsbeispiel der Figuren 1 und 2 befindet sich die Lagerstelle 34 unmittelbar an der Halterung 7, vorliegend also am Gehäuse 2. Genauer gesagt befindet sich die Lagerstelle 34 hier vorzugsweise an einem der Wandabschnitte 36 des Gehäuses 2, die die Arbeitskammer 3 oberhalb und unterhalb des Biegewandlers 4 begrenzen.

Zweckmäßigerweise ist die Lagerstelle 34 nach Art eines sogenannten Loslagers ausgeführt. Der Abstützhebel 28 liegt dabei lose auf einem von der Halterung 7 getragenen oder fest mit dieser verbundenen Lagerkörper 37 auf und kann bezüglich der Auflagestelle verschwenken, zugleich aber auch translatorische Bewegungen relativ zum Lagerkörper 37 ausführen. Letzteres hat den Vorteil, dass aufgrund des Krümmungsvorganges des Arbeitsabschnittes 5 auftretende Abstandsänderungen zwischen der Drehmoment-Einleitungsstelle 32 und der Lagerstelle 34 keine Verspannungen innerhalb des Systems auslösen, sondern der Abstützhebel 28 unmittelbar entsprechend nachgeführt wird und dabei Relativbewegungen bezüglich der Lagerstelle 34 ausführt.

Beim Aktivieren des sich im Ausgangszustand befindlichen Biegewandlers 4 bewegt sich im Falle der Ausführungsform der Figuren 1 und 2 der Arbeitsabschnitt 5 gemäß Auslenkrichtung 13a nach oben. Dabei wird der an der Drehmoment-Einleitungsstelle 32 fixierte Befestigungsabschnitt 38 des Abstützhebels 28 mitgenommen. Ohne Abstützung an der Lagerstelle 34 würde der Abstützhebel 28 dabei mit seinem entgegengesetzten Endabschnitt gemäß der gestrichelt angedeuteten Pfeilrichtung 42 in die ebenfalls gestrichelt angedeutete Stellung 43 vom Arbeitsabschnitt 5 wegschwenken. Bedingt durch die Abstützung an der Lagerstelle 34 wird diese Schwenkbewegung des Abstützhebels 28 jedoch verhindert und stattdessen aus der Halterung die schon erwähnte Abstützkraft F_{A} in den abgestützten Abschnitt 44 des Abstützhebels 28 eingeleitet. Dies führt dazu, dass im Bereich des Befestigungsabschnittes 38 ein Drehmoment in den Arbeitsabschnitt 5 eingeleitet wird, das aufgrund der endseitigen festen Einspannung des Biegewandlers 4 die kreisbogenförmige Krümmung des Arbeitsabschnittes 5 und mithin die gewünscht hohe Effizienz des Biegewandlers hervorruft.

Die Aktoreinrichtung gemäß Figuren 3 bis 7 besitzt eine Abstützeinrichtung 25, die ausgehend vom Ausgangszustand des Biegewandlers 4 bei beiden Auslenkrichtungen 13a, 13b die schon geschilderte Abstützwirkung entfaltet.

Bei diesem Ausführungsbeispiel befindet sich die Lagerstelle 34 an einem bezüglich der Halterung 2 gesonderten Lagerstellenträger 45, der einenends im Bereich der Einspannstelle 24 an der Halterung 2 starr befestigt ist und sich ausgehend von dort ein Stück weit entlang des Arbeitsabschnittes 5 erstreckt. Die endseitige Fixierung des Biegewandlers 4 erfolgt hier zweckmäßigerweise durch Einspannen des entsprechenden Endbereiches 6 im Lagerstellenträger 45, der seinerseits an der Einspannstelle 24 an der Halterung 7 befestigt ist. Ein aus dem Lagerstellenträger 45 herausragender Endabschnitt 46 des Biegewandlers 4 kann bei Bedarf allerdings zusätzlich an der Halterung 2 befestigt sein.

Der Lagerstellenträger kann ein den Arbeitsabschnitt 5 entlang eines Teils seiner Länge umschließender Hohlkörper sein, wie dies beim Ausführungsbeispiel der Fall ist. Der Arbeitsabschnitt 5 durchsetzt dabei einen Längserstreckung aufweisenden ersten Hohlraum 47 des Lagerstellenträgers 45, dessen Querschnittsabmessungen ausreichend groß sind, um beim Verschwenken des Arbeitsabschnittes 5 einen Kontakt mit dem stillstehenden Lagerstellenträger 45 zu verhindern.

Der Abstützhebel 28 ist bei diesem Ausführungsbeispiel ein in vergleichbarer Weise ausgestalteter Hohlkörper, der dadurch am Biegewandler 4 drehmomentsteif befestigt ist, dass der Biegewandler 4 an seinem freien Endbereich 16 in einer stirnseitigen Abschlusswand 48 des hohlkörperartigen Abstützhebels 28 fest eingespannt ist. Ausgehend von dort ragt der Abstützhebel 28, den Biegewandler 5 umschließend, in Richtung zum Lagerstellenträger 45, wobei sich der Arbeitsabschnitt 5 entlang eines in dem Abstützhebel 28 definierten zweiten Hohlraum 52 erstreckt, dessen Querschnittsabmessungen ausreichend groß sind, um bei allen auftretenden Relativbewegungen einen Kontakt mit dem Biegewandler 4 zu vermeiden.

Im Bereich der Lagerstelle 34 ist der Abstützhebel 28 am Lagerstellenträger 45 gelagert. Die Lagerstelle wirkt dabei ebenfalls vergleichbar einem Loslager, ist aber nach Art eines Filmscharniers 53 ausgeführt. Letzteres besteht beim Ausführungsbeispiel aus zwei in der Breitenrichtung des Biegewandlers 4 zueinander beabstandeten Scharnierelementen 54, welche den Arbeitsabschnitt 5 an seinen einander entgegengesetzten schmalen Längsseiten flankieren und eine bevorzugt einstückige Verbindung zwischen dem Abstützhebel 28 und dem Lagerstellenträger 45 herstellen.

Durch das Filmscharnier 53 wird die Schwenkbarkeit des Abstützhebels 28 in der Auslenkebene relativ zum Lagerstellenträger 45 gewährleistet. Gleichzeitig sorgt ein sich im Ausgangszustand des Biegewandlers 4 rechtwinkelig zur Hauptausdehnungsebene 14 des Biegewandlers 4 erstreckender Stegabschnitt 55 innerhalb eines jeweiligen Scharnierelementes 54 für die gewünschte Stützwirkung in der Auslenkrichtung des Arbeitsabschnittes 5. Der Stegabschnitt 55 hat allerdings die notwendige Flexibilität, um die Schwenkbarkeit des Abstützhebels 28 und zugleich auch die gegebenenfalls notwendige translatorische Beweglichkeit des Abstützhebels 28 relativ zum Lagerstellenträger 45 zu gewährleisten.

Die Scharnierelemente 54 sind bevorzugt S-förmig gestaltet, wobei das eine Ende am Lagerstellenträger 45 und das andere Ende am Abstützhebel 28 fixiert ist. Die beiden entsprechenden Verbindungsstellen 56a, 56b liegen in der Auslenkebene des Arbeitsabschnittes 5 mit Abstand zueinander diesseits und jenseits des Biegewandlers 4. Bevorzugt sind die beiden Scharnierelemente 54 spiegelbildlich zueinander angeordnet, derart, dass von den auf der gleichen Seite des Biegewandlers 4 liegenden Verbindungsstellen die jeweils eine am Lagerstellenträger 45 und die jeweils andere am Abstützhebel 28 vorgesehen ist.

Aus Figuren 6 und 7 ist gut ersichtlich, dass auch bei einer solchen Bauform der Abstützeinrichtung 25 ein Drehmoment in den Arbeitsabschnitt 5 eingeleitet wird, wenn dieser seitwärts ausgelenkt wird, sodass der Arbeitsabschnitt 5 in die angestrebte, energetisch optimale Kreisbogenform gezwungen wird.

Von Vorteil ist es, wenn sich die Lagerstelle 34, zumindest im Ausgangszustand des Biegewandlers 4, seitlich neben diesem auf Höhe seiner neutralen Faser befindet. Dies ist beim Ausführungsbeispiel der Figuren 3 bis 7 realisiert.

Bei beiden Ausführungsbeispielen sitzen das bzw. die Ventilglieder 17 am Abstützhebel 28. Eine Anbringung am Arbeitsabschnitt 5 des Biegewandlers 4 ist jedoch ebenfalls möglich.

## Patentansprüche

1. Aktoreinrichtung, mit einem bezüglich einer Halterung (7) fixierten Piezo-Biegewandler (4), der durch Anlegen einer Steuerspannung in einer Auslenkebene auslenkbar ist und der über eine Abstützeinrichtung (25) derart bezüglich der Halterung (7) abgestützt ist, dass bei seiner Auslenkung lokal ein in der Auslenkebene wirksames Drehmoment in ihn eingeleitet wird, **dadurch gekennzeichnet, dass** die Abstützeinrichtung (25) mindestens einen in sich starren Abstützhebel (28) aufweist, der zum einen drehmomentsteif an der Drehmoment-Einleitungsstelle (32) an dem sich an den fixierten Endabschnitt (6) anschließenden auslenkbaren Arbeitsabschnitt (5) des Biegewandlers (4) befestigt ist und zum anderen an einer bezüglich der Halterung (7) ortsfesten Lagerstelle (34) schwenkbeweglich abgestützt ist.

2. Aktoreinrichtung nach Anspruch 1, **dadurch gekennzeichnet, dass** der Piezo-Biegewandler (4) lediglich einenends bezüglich der Halterung (7) fixiert ist.

3. Aktoreinrichtung nach Anspruch 1 oder 2, **dadurch gekennzeichnet, dass** der Piezo-Biegewandler (4) ein- oder mehrfach, insbesondere an über seinen Umfang verteilten Stellen, bezüglich der Halterung (7) fixiert ist.

4. Aktoreinrichtung nach Anspruch 3, **dadurch gekennzeichnet, dass** der Piezo-Biegewandler (4) an einer Membran (9) angeordnet ist, die umfangsseitig entweder ringsum durchgehend oder an mehreren zueinander beabstandeten Stellen mit mindestens einem elastischen Aufhängungsabschnitt (10) über den Rand des Piezo-Biegewandlers hinausragt, wobei sie über den/die hinausragenden Abschnitt(e) an der beispielsweise von einem Gehäuse gebildeten Halterung (7) fixiert ist.

5. Aktoreinrichtung nach einem der Ansprüche 1 bis 4, **dadurch gekennzeichnet, dass** die Abstützeinrichtung (25) so ausgeführt ist, dass sich die Drehmoment-Einleitungsstelle (32) im Bereich der Stellkraft-Abgabestelle (15) des Biegewandlers (4) befindet.

6. Aktoreinrichtung nach einem der Ansprüche 1 bis 4, **dadurch gekennzeichnet, dass** die Abstützeinrichtung (25) so ausgeführt ist, dass die Drehmoment-Einleitungsstelle (32) und die Stellkraft-Abgabestelle (15) mit Abstand zueinander angeordnet sind.

7. Aktoreinrichtung nach einem der Ansprüche 1 bis 6, **dadurch gekennzeichnet, dass** die Abstützeinrichtung (25) so ausgeführt ist, dass sich die Drehmoment-Einleitungsstelle (32) im Bereich des dem fixierten Endbereich (6) entgegengesetzten Endbereiches (16) des Biegewandlers (4) befindet.

8. Aktoreinrichtung nach einem der Ansprüche 1 bis 7, **dadurch gekennzeichnet, dass** sich der Abstützhebel (28) längsseits neben dem Arbeitsabschnitt (5) des Biegewandlers (4) erstreckt.

9. Aktoreinrichtung nach Anspruch 8, **dadurch gekennzeichnet, dass** der Abstützhebel (28) einenends über den Biegewandler (4) hinausragt.

10. Aktoreinrichtung nach einem der Ansprüche 1 bis 9, **dadurch gekennzeichnet, dass** die Lagerstelle (34) näher bei dem bezüglich der Halterung (7) fixierten Endbereich (6) des Biegewandlers (4) liegt als die Drehmoment-Einleitungsstelle (32).

11. Aktoreinrichtung nach einem der Ansprüche 1 bis 10, **dadurch gekennzeichnet, dass** die Lagerstelle (34) nach Art eines Loslagers ausgeführt ist, an dem der Abstützhebel (28) schwenkbar und verschiebbar abgestützt ist.

12. Aktoreinrichtung nach einem der Ansprüche 1 bits 11, **dadurch gekennzeichnet, dass** die Lagerstelle (34) als Filmscharnier (53) mit mindestens einem in der Auslenkrichtung (13a, 13b) des Arbeitsabschnittes (5) eine Stützwirkung entfaltenden Stegabschnitt (55) ausgeführt ist.

13. Aktoreinrichtung nach einem der Ansprüche 1 bis 12, **dadurch gekennzeichnet, dass** sich der mindestens eine Abstützhebel (28), bei horizontaler Ausrichtung des Biegewandlers (4) gesehen, oberhalb und/oder unterhalb und/oder seitlich des Arbeitsabschnittes (5) des Biegewandlers (4) erstreckt.

14. Aktoreinrichtung nach einem der Ansprüche 1 bis 13, **dadurch gekennzeichnet, dass** sich die Lagerstelle (34) unmittelbar an der Halterung (7) befindet.

15. Aktoreinrichtung nach einem der Ansprüche 1 bis 14, **dadurch gekennzeichnet, dass** sich die Lagerstelle (34) an einem an der Halterung (7) befestigten Lagerstellenträger (45) befindet, der sich ausgehend von dort ein Stück weit längs des Biegewandlers (4) erstreckt.

16. Aktoreinrichtung nach Anspruch 15, **dadurch gekennzeichnet, dass** der Lagerstellenträger (45) ein den Arbeitsabschnitt (5) des Biegewandlers (4) entlang eines Teils seiner Länge umschließender Hohlkörper ist, wobei die Querschnittsabmessungen des Hohlraumes (47) so groß sind, dass die beiden Komponenten (4, 45) kollisionsfrei relativ zueinander verschwenkbar sind.

17. Aktoreinrichtung nach einem der Ansprüche 1 bis 16, **dadurch gekennzeichnet, dass** der Abstützhebel (28) ein den Arbeitsabschnitt (5) entlang eines Teils seiner Länge umschließender Hohlkörper ist, wobei die Querschnittsabmessungen des Hohlraumes (52) so groß sind, dass die beiden Komponenten (28, 5) kollisionsfrei relativ zueinander verschwenkbar sind.

18. Aktoreinrichtung nach einem der Ansprüche 1 bis 17, **dadurch gekennzeichnet, dass** sich die Lagerstelle (34) etwa mittig zwischen der Drehmoment-Einleitungsstelle (32) und dem an der Halterung (7) fixierten Endabschnitt (6) des Biegewandlers (4) befindet.

19. Aktoreinrichtung nach einem der Ansprüche 1 bis 18, **dadurch gekennzeichnet, dass** sich die Lagerstelle (34) seitlich neben dem Biegewandler (4) auf Höhe dessen neutraler Faser befindet.

20. Aktoreinrichtung nach einem der Ansprüche 1 bis 19, **dadurch gekennzeichnet, dass** die Halterung (7) Bestandteil eines den Biegewandler (4) umschließenden Gehäuses (2) ist.

21. Aktoreinrichtung nach einem der Ansprüche 1 bis 20, **dadurch gekennzeichnet, dass** bei einem Biegewandler (4) mit aktiv in zwei einander entgegengesetzte Richtungen auslenkbarem Arbeitsabschnitt (5) eine bei beiden Auslenkrichtungen (13a, 13b) wirksame Abstützeinrichtung (25) vorgesehen ist.

22. Aktoreinrichtung nach einem der Ansprüche 1 bis 21, **gekennzeichnet durch** eine Ausgestaltung als zur Steuerung von Fluidströmen dienendes Ventil, wobei an dem Biegewandler (4) und/oder an der Abstützeinrichtung (25) mindestens ein relativ zu einem Ventilsitz (18) auslenkbares Ventilglied (17) angeordnet ist.

## Claims

1. Actuator device with a piezoelectric bending transducer (4) fixed relative to a holder (7), which can be deflected in a deflection plane by the application of a control voltage and which is so supported relative to the holder (7) by a supporting device (25) that a torque effective in the deflection plane is locally introduced as it is deflected, **characterised in that** the supporting device (25) comprises at least one rigid supporting lever (28), which is on the one hand torque-rigidly secured to the deflectable operating section (5) adjoining the fixed end section (6) at the torque introduction point (32) and is on the other hand pivotably supported on a point of support (34) which is stationary relative to the holder (7).

2. Actuator device according to claim 1, **characterised in that** the piezoelectric bending transducer (4) is fixed relative to the holder (7) at one end only.

3. Actuator device according to claim 1 or 2, **characterised in that** the piezoelectric bending transducer (4) is fixed relative to the holder (7) in one or more positions, in particular at points distributed along its circumference.

4. Actuator device according to claim 3, **characterised in that** the piezoelectric bending transducer (4) is located on a diaphragm (9), the circumference of which, either continuously or at a plurality of spaced points, projects over the edge of the piezoelectric bending transducer with at least one elastic suspension section, being secured to the holder (7), which is for example represented by a housing, by way of the projecting section(s).

5. Actuator device according to any of claims 1 to 4, **characterised in that** the supporting device (25) is designed such that the torque introduction point (32) lies in the region of the actuating force output point (15) of the bending transducer (4).

6. Actuator device according to any of claims 1 to 4, **characterised in that** the supporting device (25) is designed such that the torque introduction point (32) and the actuating force output point (15) are arranged at a distance relative to one another.

7. Actuator device according to any of claims 1 to 4, **characterised in that** the supporting device (25) is designed such that the torque introduction point (32) is located in the end region (16) of the bending transducer (4) which is opposite the fixed end region (6).

8. Actuator device according to any of claims 1 to 7, **characterised in that** the supporting lever (28) extends along the operating section (5) of the bending transducer (4).

9. Actuator device according to claim 8, **characterised in that** one end of the supporting lever (28) projects from the bending transducer (4).

10. Actuator device according to any of claims 1 to 9, **characterised in that** the point of support (34) is located closer to the end region (6) of the bending transducer (4) which is fixed relative to the holder (7) than the torque introduction point (32).

11. Actuator device according to any of claims 1 to 10, **characterised in that** the point of support (34) is designed as a type of movable bearing on which the supporting lever (28) is pivotably and slidably supported.

12. Actuator device according to any of claims 1 to 11, **characterised in that** the point of support (34) is designed as a film hinge (53) with at least one web section (55) offering a supporting effect in the deflection direction (13a, 13b) of the operating section (5).

13. Actuator device according to any of claims 1 to 12, **characterised in that** the at least one supporting lever (28) extends above and/or below and/or adjacent to the operating section (5) of the bending transducer (4) as viewed in the horizontal orientation of the bending transducer (4).

14. Actuator device according to any of claims 1 to 13, **characterised in that** the point of support (34) is directly located on the holder (7).

15. Actuator device according to any of claims 1 to 14, **characterised in that** the point of support (34) is located on a point of support base (45) secured to the holder (7) and extending from there along a section of the bending transducer (4).

16. Actuator device according to claim 15, **characterised in that** the point of support base (45) is a hollow body enclosing a part of the length of the operating section (5) of the bending transducer (4), wherein the cross-sectional dimensions of the hollow space (47) are large enough to allow the two components (4, 45) to pivot relative to one another without collision.

17. Actuator device according to any of claims 1 to 16, **characterised in that** the supporting lever (28) is a hollow body enclosing a part of the length of the operating section (5), wherein the cross-sectional dimensions of the hollow space (52) are large enough to allow the two components (28, 5) to pivot relative to one another without collision.

18. Actuator device according to any of claims 1 to 17, **characterised in that** the point of support (34) is located approximately in the middle between the torque introduction point (32) and the end section (6) of the bending transducer (4) which is secured to the holder (7).

19. Actuator device according to any of claims 1 to 18, **characterised in that** the point of support (34) is located laterally adjacent to the bending transducer (4) at the level of its neutral fibre.

20. Actuator device according to any of claims 1 to 19, **characterised in that** the holder (7) is a part of a housing (2) enclosing the bending transducer (4).

21. Actuator device according to any of claims 1 to 20, **characterised in that**, in a bending transducer (4) with an operating section (5) actively deflectable in opposite directions, a supporting device (25) effective in both deflection directions (12a, 13b) is provided.

22. Actuator device according to any of claims 1 to 21, **characterised by** being designed as a valve for the control of fluid flows, wherein at least one valve member (17) deflectable relative to a valve seat (18) is provided on the ending transducer (4) and/or on the supporting device (25).

## Revendications

1. Dispositif actionneur avec un transducteur de flexion piézoélectrique (4) fixé par rapport à un support (7) qui peut être dévié dans un plan de déviation par l'application d'une tension de commande et qui est soutenu par rapport au support (7) par l'intermédiaire d'un dispositif d'appui (25) de telle manière qu'un couple de rotation agissant localement dans le plan de déviation est introduit dans ce dispositif lors de sa déviation, **caractérisé en ce que** le dispositif d'appui (25) comporte au moins un levier d'appui (28) rigide en soi qui est, d'une part, fixé de manière rigide en présence du couple de rotation, au tronçon de travail (5) du transducteur de flexion (4) pouvant être dévié, raccordé au tronçon d'extrémité fixe (6), au point d'introduction du couple de rotation (32) et qui, d'autre part, s'appuie de manière pivotante au niveau d'un point d'appui (34) stationnaire par rapport au support (7).

2. Dispositif actionneur selon la revendication 1, **caractérisé en ce que** le transducteur de flexion piézoélectrique (4) est seulement fixé à une extrémité par rapport au support (7).

3. Dispositif actionneur selon la revendication 1 ou 2, **caractérisé en ce que** le transducteur de flexion piézoélectrique (4) est fixé une ou plusieurs fois, en particulier en des endroits répartis sur sa périphérie, par rapport au support (7).

4. Dispositif actionneur selon la revendication 3, **caractérisé en ce que** le transducteur de flexion piézoélectrique (4) est disposé sur une membrane (9) qui dépasse au-delà du bord du transducteur de flexion piézoélectrique du côté de la périphérie, soit tout autour en continu soit en plusieurs endroits espacés les uns des autres avec au moins un tronçon de suspension élastique (10), la membrane étant fixée au support (7) formé, par exemple, par un boîtier au moyen du/des tronçon(s) dépassant(s).

5. Dispositif actionneur selon l'une des revendications 1 à 4, **caractérisé en ce que** le dispositif d'appui (25) est réalisé de telle manière que le point d'introduction du couple de rotation (32) se trouve dans la zone du point d'émission de la puissance de réglage (15) du transducteur de flexion (4).

6. Dispositif actionneur selon l'une des revendications 1 à 4, **caractérisé en ce que** le dispositif d'appui (25) est réalisé de telle manière que le point d'introduction du couple de rotation (32) et le point d'émission de la puissance de réglage (15) sont disposés à distance l'un de l'autre.

7. Dispositif actionneur selon l'une des revendications 1 à 6, **caractérisé en ce que** le dispositif d'appui (25) est réalisé de telle manière que le point d'introduction du couple de rotation (32) se trouve dans la zone de la région d'extrémité (16) opposée à la zone d'extrémité fixe (6) du transducteur de flexion (4).

8. Dispositif actionneur selon l'une des revendications 1 à 7, **caractérisé en ce que** le levier d'appui (28) s'étend le long du côté du tronçon de travail (5) du transducteur de flexion (4).

9. Dispositif actionneur selon la revendication 8, **caractérisé en ce que** le levier d'appui (28) dépasse à une extrémité au-delà du transducteur de flexion (4).

10. Dispositif actionneur selon l'une des revendications 1 à 9, **caractérisé en ce que** le point d'appui (34) est plus près de la zone d'extrémité (6) du transducteur de flexion (4) fixe par rapport au support (7) que le point d'introduction du couple de rotation (32).

11. Dispositif actionneur selon l'une des revendications 1 à 10, **caractérisé en ce que** le point d'appui (34) est réalisé à la manière d'un palier libre sur lequel le levier d'appui (28) s'appuie de manière pivotante et mobile en coulissement.

12. Dispositif actionneur selon l'une des revendications 1 à 11, **caractérisé en ce que** le point d'appui (34) est réalisé sous forme de charnière à film (53) avec au moins un tronçon allongé de dépliage (55) produisant un effet d'appui dans la direction de déviation (13a, 13b) du tronçon de travail (5).

13. Dispositif actionneur selon l'une des revendications 1 à 12, **caractérisé en ce que** le au moins un levier d'appui (28), vu suivant l'orientation horizontale du transducteur de flexion (4), s'étend au-dessus et/ou en dessous et/ou sur le côté du tronçon de travail (5) du transducteur de flexion (4).

14. Dispositif actionneur selon l'une des revendications 1 à 13, **caractérisé en ce que** le point d'appui (34) se trouve directement sur le support (7).

15. Dispositif actionneur selon l'une des revendications 1 à 14, **caractérisé en ce que** le point d'appui (34) se trouve sur un support de point d'appui (45) fixé au support (7) qui s'étend à partir de là sur une certaine distance le long du transducteur de flexion (4).

16. Dispositif actionneur selon la revendication 15, **caractérisé en ce que** le support de point d'appui (45) est un corps creux entourant le tronçon de travail (5) du transducteur de flexion (4) le long d'une partie de sa longueur, les dimensions en coupe transversale de l'espace creux (47) étant telles que les deux composants (4, 45) peuvent pivoter l'un par rapport à l'autre sans collision.

17. Dispositif actionneur selon l'une des revendications 1 à 16, **caractérisé en ce que** le levier d'appui (28) est un corps creux entourant le tronçon de travail (5) le long d'une partie de sa longueur, les dimensions en coupe transversale de l'espace creux (52) étant telles que les deux composants (4, 45) peuvent pivoter l'un par rapport à l'autre sans collision.

18. Dispositif actionneur selon l'une des revendications 1 à 17, **caractérisé en ce que** le point d'appui (34) se trouve à peu près au milieu entre le point d'introduction du couple de rotation (32) et le tronçon d'extrémité (6) du transducteur de flexion (4) fixé au support (7).

19. Dispositif actionneur selon l'une des revendications 1 à 18, **caractérisé en ce que** le point d'appui (34) se situe latéralement à côté du transducteur de flexion (4) à la hauteur de la fibre neutre de celui-ci.

20. Dispositif actionneur selon l'une des revendications 1 à 19, **caractérisé en ce que** le support (7) fait partie d'un boîtier (2) entourant le transducteur de flexion (4).

21. Dispositif actionneur selon l'une des revendications 1 à 20, **caractérisé en ce que**, dans le cas d'un transducteur de flexion (4) avec un tronçon de travail (5) pouvant être dévié activement dans deux directions opposées, il est prévu un dispositif d'appui (25) agissant dans les deux directions de déviation (13a, 13b).

22. Dispositif actionneur selon l'une des revendications 1 à 21, **caractérisé en ce qu'**il est conçu comme une soupape utilisée pour la commande d'écoulement de fluides, dans laquelle au moins un élément de soupape (17) pouvant être dévié par rapport à un siège de soupape (18) est disposé sur le transducteur de flexion (4) et/ou sur le dispositif d'appui (25).
